# FASCICULE DE BREVET EUROPEEN

(11) **EP 0 678 801 B1**
(45) Date de publication et mention de la délivrance du brevet: **18.09.1996**
(21) Numéro de dépôt: 95470014.2
(22) Date de dépôt: 14.04.1995
(51) Int. Cl.: G05F 3/24, G11C 16/06

(54) **Circuit régulateur avec référence ZENER**
Regelschaltung mit Zenerreferenz
Regulator circuit with Zener reference

(30) Priorité: 21.04.1994 FR 9404983
(43) Date de publication de la demande: 25.10.1995
(73) Titulaire: SGS-THOMSON MICROELECTRONICS S.A., F-94250 Gentilly (FR)
(72) Inventeur: Drouot, Sylvie, F-57000 Metz (FR); Silvestre de Ferron, Gérard, FR-57000 Metz (FR)
(74) Mandataire: Schmit, Christian Norbert Marie

(56) Documents cités:
- EP-A- 0 342 581
- EP-A- 0 539 593
- DATABASE WPI Derwent Publications Ltd., London, GB; AN 93093410 & US-A-5 191 232 (SILICON STORAGE TECHNOLOGY) , 17 Mars 1992

## Description

L'invention concerne un circuit régulateur de tension, utilisant une diode Zener pour produire une tension de référence stable, des moyens de comparaison pour comparer une tension d'alimentation avec cette tension de référence, et des moyens de régulation pour limiter la tension d'alimentation en conséquence. Il trouve, par exemple, une application pour limiter la valeur de la tension de sortie d'un circuit multiplicateur de tension.

Dans nombre d'applications électroniques, on est amené à utiliser des circuits pour produire des tensions analogiques d'alimentation adaptées au bon fonctionnement de l'application. On peut ainsi, à partir d'une alimentation de base, pile ou secteur, être amené à développer des circuits permettant de diminuer ou augmenter la tension d'alimentation de base disponible. Par exemple, on ne pourra alimenter directement en 220 Volts un microprocesseur d'un ordinateur branché sur le secteur, sous peine de destruction. A l'opposé, si on souhaite réaliser un appareil de mesure de fortes impédances alimenté par une pile, on sera amené à développer un circuit d'alimentation à découpage afin de bénéficier de courants de mesure suffisants. Un circuit donné pourra également être composé de différents modules nécessitant la production de tensions d'alimentation propres à ces modules. Par exemple, si on souhaite alimenter un microcontrôleur, composé au moins d'un microprocesseur et d'une mémoire morte, on pourra être amené à produire des tensions d'alimentation de valeurs différentes pour le microprocesseur et la mémoire.

En effet, si on considère une mémoire de type MOS organisée matriciellement en cellules composées de transistors MOS, on pourra être obligé de prévoir des circuits d'alimentation internes à celle-ci pour produire des tensions spécifiques afin de polariser les grilles de commande de ces transistors. Typiquement, on produira à l'aide de multiplicateurs de tension des tensions d'alimentation supérieures à la tension nominale du circuit (de l'ordre de 3 à 5 Volts).

Classiquement, un circuit multiplicateur de tension (appelé aussi pompe de charge), permet de produire une tension de sortie, à partir d'une tension d'alimentation reçue, en chargeant et en déchargeant un ou plusieurs condensateurs consécutivement, de telle façon que la tension de sortie soit supérieure à la tension d'alimentation reçue. La tension de sortie augmente progressivement pour atteindre une valeur asymptotique égale typiquement à un multiple de la tension d'alimentation reçue. Par exemple, pour produire une tension de sortie égale à deux fois la tension reçue, on peut utiliser un circuit dit "doubleur de Schenkel". Un inconvénient de ce type de circuit est que la tension de sortie augmente de moins en moins rapidement au fur et à mesure du temps. On est donc amené, pour diminuer le temps nécessaire pour atteindre la tension de sortie voulue, à surdimensionner le multiplicateur et à le limiter en sortie. Par exemple, au lieu d'utiliser un circuit qui double la tension reçue, on utilise un circuit qui la triple et on limite la tension de sortie à deux fois la tension reçue une fois que cette valeur est atteinte.

Pour limiter ainsi la valeur de la tension de sortie, on peut utiliser typiquement un régulateur parallèle. Les régulateurs contiennent trois éléments de base : une tension de référence de précision, un amplificateur d'erreur et un élément de commande de puissance. Les différents sous-ensembles d'un régulateur sont connectés en une boucle de contre-réaction négative de telle sorte que la tension de sortie est contrôlée et reste constante.

Le plus simple des régulateurs consiste en une diode Zener connectée en parallèle sur une charge alimentée par la tension de sortie. Par charge, on entend par exemple la capacité équivalente à un ensemble de grilles de commande de transistors MOS d'une mémoire. Un inconvénient de ce type de régulateur est de fixer la tension de sortie à une fois ou à un multiple (dans le cas de plusieurs diodes montées en série) de la tension inverse d'une diode Zener. Ainsi, on ne peut limiter la tension à une valeur plus faible que la tension inverse de la diode Zener. En effet, il faut alimenter la diode à une tension supérieure à cette tension inverse pour obtenir cette valeur de référence. Or, on souhaite de plus en plus développer des produits qui fonctionnent avec une tension d'alimentation basse, de l'ordre de 3 Volts. Si on souhaite par exemple produire une tension de 4,5 Volts, on ne pourra alimenter une diode dont la valeur de tension inverse est de 5,5 Volts dans l'état actuel de la technique.

Classiquement, on connaît également, dans le cas où la tension de sortie désirée est supérieure à la tension inverse d'une diode Zener de référence, des régulateurs, où l'on connecte en parallèle à la charge, un transistor commandé par la sortie d'un comparateur. En entrée de ce comparateur, on compare la tension inverse à une fraction de la tension de sortie prélevée à l'aide d'un pont diviseur de tension.

On pourrait donc imaginer d'adapter ce système en divisant ainsi la tension de référence. Cette solution n'est pas acceptable. En effet, cela implique de monter une chaîne résistive en parallèle avec une charge capacitive et à diminuer ainsi le temps de montée de la tension de sortie (on est dans l'hypothèse d'un circuit multiplicateur de tension qui ne fonctionne correctement que pour alimenter des circuits capacitifs).

On ne peut également pas comparer directement la tension inverse et la tension à limiter. D'une part c'est impossible si on souhaite limiter cette tension de sortie à une valeur inférieure à la valeur de la tension inverse et, d'autre part, dans le cas contraire, on se heurte à un problème de fonctionnement du comparateur, si la tension d'alimentation disponible pour ce comparateur est inférieure aux tensions à comparer. EP-A-0 342 581 décrit un circuit élévateur de tension. Il décrit, plus particulièrement, un circuit pour produire une tension de sortie supérieure à la tension d'alimentation du circuit et à la tension d'avalanche du circuit semiconducteur.

Au vu de ce qui précède, le but de la présente invention est de proposer un circuit régulateur de tension qui permette de limiter une tension à une valeur inférieure à une tension de référence, l'une de ces deux tensions ou ces deux tensions étant supérieures à une tension d'alimentation.

Suivant l'invention, ce but est atteint par un circuit régulateur de tension pour limiter une tension d'alimentation interne produite par un circuit d'alimentation à partir d'une tension d'alimentation, ce circuit régulateur comprenant une diode zener pour produire une tension de référence, caractérisé en ce qu'il comprend en outre un étage différentiel dissymétrique recevant en entrée les tensions interne et de référence, cet étage produisant à partir de la tension interne et de la tension de référence des tensions de valeurs inférieures à la valeur de la tension d'alimentation, ces tensions étant fournies à un comparateur pour commander des moyens de limitation afin de réguler la tension d'alimentation interne.

De préférence, l'étage différentiel dissymétrique comprend deux entrées et deux sorties, la première entrée étant connectée à la grille de commande d'un premier transistor monté en série avec une première résistance entre une borne d'entrée d'alimentation recevant la tension d'alimentation et une borne de référence recevant une tension de référnce, la deuxième entrée étant connectée à la grille de commande d'un deuxième transistor monté en série avec une deuxième résistance entre la borne d'entrée d'alimentation et la borne de référence, la première sortie étant formée par le point milieu des premiers transistor et résistance, la deuxième sortie étant formée par le point milieu des deuxièmes transistor et résistance.

La tension interne et la tension de référence étant appliquées à des grilles de commande de transistors, on ne prélève plus de courant sur une éventuelle charge capacitive pour produire des tensions de comparaison plus basses. Pour fixer la valeur maximale de la tension interne, il suffira de déterminer en conséquence les valeurs des résistances de l'étage différentiel. On pourra ainsi fixer une valeur maximale inférieure à la valeur de la tension de référence.

De préférence, le circuit comporte un deuxième circuit multiplicateur de tension pour alimenter sur une sortie la diode Zener.

Ainsi, on résout le problème de l'alimentation de la diode Zener car elle n'est plus alimentée par le circuit produisant la tension interne.

De préférence, les moyens de limitation comprennent une résistance montée en série avec un transistor de limitation.

De préférence, le transistor de limitation a sa grille de commande connectée à la sortie du comparateur.

De préférence, les moyens de limitation comprennent un deuxième transistor de limitation dont la grille de commande est connectée à la sortie du deuxième circuit multiplicateur de tension.

De préférence, le circuit comprend des moyens de commande pour inhiber le circuit régulateur de tension quand un signal binaire de commande de limitation est dans un premier état.

L'invention sera mieux comprise et d'autres particularités et avantages apparaîtront à la lecture de la description détaillée ci-après d'un exemple de réalisation préféré. Cette description n'est donnée qu'à titre indicatif et nullement limitatif de l'invention, et est illustrée par les figures suivantes :
- figure 1 : circuit réalisé conformément à l'invention,
- figure 2 : circuit multiplicateur de tension utilisé pour produire le signal de décharge,
- figure 3 : variante du circuit réalisé conformément à l'invention et comprenant des moyens de sélection pour désactiver le circuit de limitation.

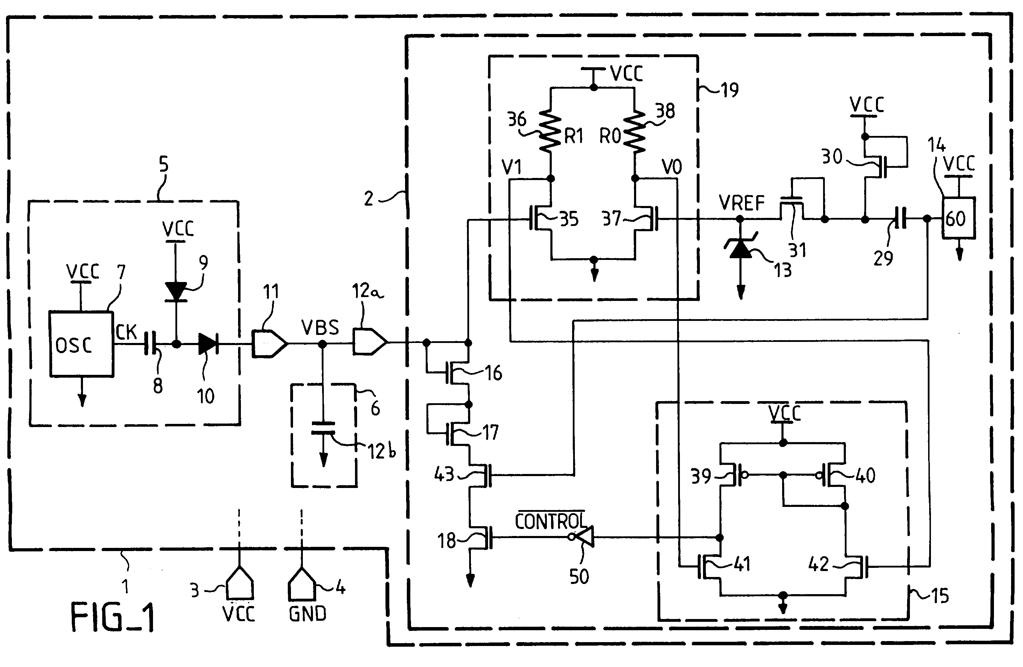

On supposera que les circuits illustrés sur les figures 1 à 3 sont réalisés en technologie CMOS.

La figure 1 illustre un circuit intégré 1 comprenant un circuit régulateur de tension 2.

On notera que la description se fait en référence à un circuit intégré comprenant un circuit multiplicateur de tension et un circuit régulateur de tension, l'invention pouvant être avantageusement utilisée dans une mémoire de type électriquement programmable. On pourrait néanmoins, sans sortie du cadre de l'invention, imaginer que le circuit régulateur de tension est implanté dans un circuit intégré indépendant, voire que ce circuit soit réalisé à l'aide de composants discrets.

Ce circuit 1 comprend :
- une borne d'entrée d'alimentation 3 pour recevoir une tension d'alimentation VCC,
- une borne d'entrée de référence 4 pour recevoir une tension de référence GND.

En pratique, la borne d'entrée 4 est une masse. Dans un exemple, VCC vaudra 3 Volts.

Le circuit 1 comprend par ailleurs un premier multiplicateur de tension 5 et un circuit capacitif 6 alimenté par ce circuit multiplicateur de tension 5.

Le circuit multiplicateur de tension 5 comprend un oscillateur 7 alimenté par la tension d'alimentation VCC et la masse délivrant un signal d'horloge CK. Le signal d'horloge CK est appliqué à la première borne d'un condensateur 8 dont la deuxième borne est connectée à la borne d'alimentation 3 par le biais d'une diode 9 et à une borne de sortie 11 par le biais d'une diode d'isolation 10.

On modélise le circuit capacitif 6 par un condensateur 12b connecté entre la borne de sortie 11 et la masse 4.

Le condensateur 12b représente par exemple un ensemble de grilles de commande de transistors à effet de champ utilisés dans des cellules de mémorisation d'une mémoire morte électriquement programmable.

On se place dans l'hypothèse d'un circuit multiplicateur de Schenkel qui double la tension d'alimentation VCC.

On appelle tension interne VBS la tension présente sur la borne de sortie 11. C'est cette tension VBS que l'on souhaite limiter. Dans un exemple, on limitera VBS à 4,5 Volt, c'est à dire à une valeur maximale comprise entre la valeur de la tension d'alimentation VCC et la valeur maximale pouvant être atteinte par le doubleur de Schenkel.

Le circuit régulateur 2 comprend :
- une entrée 12a pour recevoir la tension interne VBS ,
- des moyens de référence 13, 14 et 29 à 31 pour produire une tension de référence VREF,
- un comparateur 15 à deux entrées pour commander des moyens de limitation 16 à 18 pour limiter la valeur de la tension interne VBS à une valeur maximale VBSM,
- un étage différentiel 19 recevant la tension interne VBS et la tension de référence VREF.

Les moyens de référence comportent une diode Zener 13 dont l'anode est connectée à la masse 4 et dont la cathode est connectée à la sortie 60 d'un deuxième circuit multiplicateur de tension 14 par le biais d'une diode 31 et d'un condensateur 29.

Dans un exemple, on considère que la tension inverse de la diode Zener est de 5,5 Volts, c'est-à-dire supérieure à la fois à la tension interne maximale VBS et à la tension d'alimentation VCC.

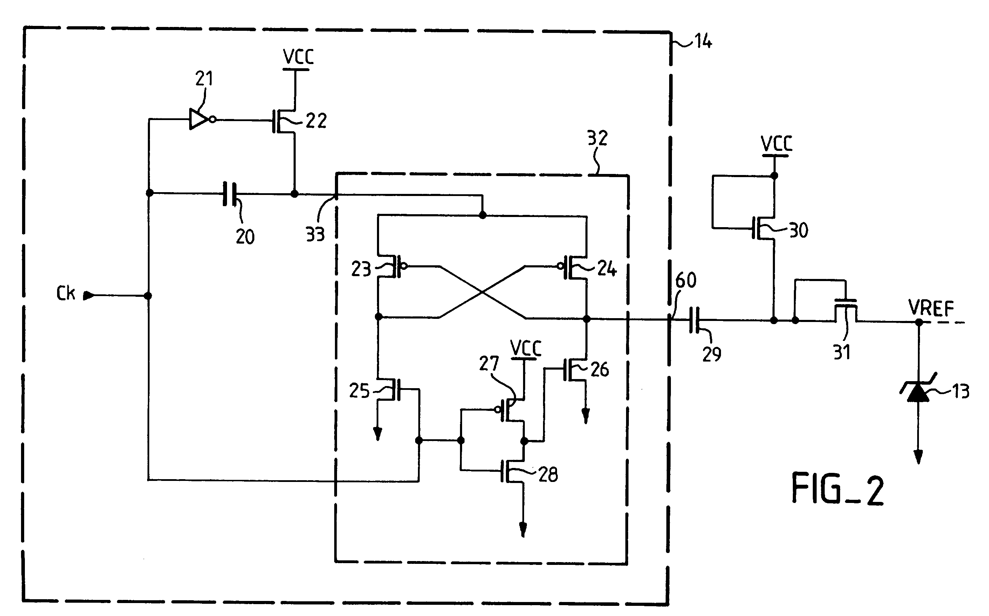

Le circuit multiplicateur de tension 14, illustré à la figure 2, comprend un condensateur 20 qui reçoit sur une de ses bornes un signal d'horloge CK. Dans un exemple, ce signal d'horloge est identique au signal d'horloge délivré par l'oscillateur du premier circuit multiplicateur de tension 5. Le circuit 14 pourrait également comporter un oscillateur pour délivrer un signal d'horloge différent. La deuxième borne du condensateur 20 est connectée à la borne d'alimentation 3 par le biais d'un transistor de type NMOS 22. La grille de commande de ce transistor 22 reçoit le signal d'horloge CK par le biais d'un inverseur 21. Ainsi, cette deuxième borne va être alternativement portée au potentiel de VCC quand le signal d'horloge CK sera à l'état bas (potentiel de masse) et à 2 * VCC quand ce signal CK sera à l'état haut (potentiel de VCC).

Le circuit multiplicateur de tension 14 comporte également un commutateur 32.

Ce commutateur 32 reçoit, sur une entrée 34, le signal d'horloge CK. Ce signal d'horloge CK est appliqué à l'entrée d'un inverseur composé de deux transistors 27 et 28, de type respectivement PMOS et NMOS, montés en série entre la borne d'alimentation 3 et la masse 4.

Cet inverseur délivre donc sur sa sortie le signal d'horloge CK. Le commutateur 32 comporte par ailleurs deux branches composées de deux transistors de type respectivement PMOS et NMOS montés en série entre une entrée 33 et la masse 4. L'entrée 33 est connectée à la deuxième borne du condensateur 20.

Le transistor de type NMOS 25 de la première branche a sa grille de commande connectée à l'entrée de l'inverseur. Le transistor de type NMOS 26 de la seconde branche a sa grille de commande connectée à la sortie de ce même inverseur. Le transistor de type PMOS 23 de la première branche a sa grille de commande connectée au point milieu des transistors 24 et 26 de la seconde branche. Le transistor de type PMOS 24 de la seconde branche a sa grille de commande connectée au point milieu des transistors 23 et 25 de la première branche.

Le commutateur comporte enfin une sortie, correspondant à la sortie 60 du circuit multiplicateur de tension 14. Cette sortie est connectée au point milieu des transistors 24 et 26 de la deuxième branche du commutateur.

La sortie 60 du circuit multiplicateur de tension 14 est donc soit au potentiel de masse, soit à 2 * VCC suivant que le signal d'horloge CK est bas ou haut.

On a ainsi une manière d'alimenter la diode Zener 13 à partir de la tension d'alimentation VCC. Pour pallier à d'éventuelles pertes, dues par exemple à des capacités parasites, on pourra envisager de rajouter un étage de multiplication en connectant la sortie 60 du circuit 14 à une première borne d'un condensateur 29. On connectera la deuxième borne de ce condensateur 29 à la borne d'alimentation 3 par le biais d'un transistor de type NMOS 30 monté en diode. On connectera la cathode de la diode Zener 13 à la deuxième borne de ce condensateur 29 par le biais d'un transistor de type NMOS 31 monté en diode. On alimentera ainsi la diode Zener 13 avec une tension pouvant atteindre 3 * VCC. Pour limiter le courant inverse traversant la diode Zener 13, on prendra soin de choisir un rapport largeur de grille sur longueur de grille tel que le transistor de type NMOS 31 soit résistif (par exemple en prenant un rapport 2/5, les dimensions étant exprimées en micromètres). Dans le cas où on se passerait du dernier étage de multiplication, c'est du transistor 24 du commutateur 32 que dépendra la valeur du courant inverse parcourant la diode Zener 13.

L'étage différentiel 19 du circuit de limitation 2 comprend deux entrées et deux sorties.

La première entrée de l'étage 19 est connectée à la grille de commande d'un transistor de type NMOS 35 monté en série avec une résistance 36 entre la borne d'alimentation 3 et la masse 4.

La deuxième entrée de l'étage 19 est connectée à la grille de commande d'un transistor de type NMOS 37 monté en série avec une résistance 38 entre la borne d'alimentation 3 et la masse 4.

La première sortie de cet étage 19 est formée par le point milieu du transistor 35 et de la résistance 36.

La seconde sortie de cet étage 19 est formée par le point milieu du transistor 37 et de la résistance 38.

On appellera R1 la valeur de la résistance 36, I1 le courant parcourant la branche formée de cette résistance 36 et du transistor 35, et V1 la tension présente sur la première sortie.

On appellera R0 la valeur de la résistance 38, I0 le courant parcourant la branche formée de cette résistance 38 et du transistor 37, et V0 la tension présente sur la deuxième sortie.

L'étage différentiel reçoit VBS sur sa première entrée et VREF sur sa deuxième entrée.

On a V1 = VCC - R * I1 et V0 = VCC - R0 * IO. Si on considère des transistors 35 et 37 identiques, les tensions V1 et V0 seront fonction des valeurs des résistances R1 et R0, et des tensions d'entrée VBS et VREF. Les valeurs de V1 et V0 seront dans tous les cas inférieures à la valeur de VCC.

Le comparateur 15 comporte classiquement deux branches constituées chacune de deux transistors de type respectivement PMOS et NMOS montés entre la borne d'alimentation 3 et la masse 4. Les transistors PMOS 39 et 40, de la première et la seconde branches, forment une source de courant. Leurs grilles de commande sont reliées et celle du transistor 40 de la seconde branche est connectée au drain de ce même transistor 40.

Le transistor de type NMOS 41 de la première branche reçoit V0 sur sa grille de commande (entrée du comparateur), et le transistor de type NMOS 42 de la seconde branche reçoit V1 sur sa grille de commande (entrée + du comparateur).

Ainsi, si VBS < R1/R0 * VREF alors V1 > V0
et si VBS ≥ R1/R0 * VREF alors V1 ≤ V0

Dans l'exemple considéré, on R1/R0 ≃ 0,8.

Par ailleurs, on fixera les valeurs de R1 et R0 de telle manière que les tensions V0 et V1 soient inférieures à VCC, afin que le comparateur fonctionne correctement.

La sortie du comparateur 15 est formée par le point milieu des transistors de la première branche de se comparateur. On appellera CONTROL le signal en sortie du comparateur. Si V1 > V0, alors CONTROL est au 0 logique (potentiel de masse).

Si V1 ≤ V0, alors CONTROL est au 1 logique (potentiel VCC).

Les moyens de limitation du circuit de limitation de tension 2 comportent :
- des transistors de limitation de courant de type NMOS 16 et 17 montés en diode et placés en série,
- un premier transistor de limitation de tension de type NMOS 43 monté en série avec les transistors 16 et 17,
- un deuxième transistor de limitation de tension de type NMOS 18 monté en série avec le premier transistor 18 et dont la source est connectée à la masse 4.

La grille de commande du premier transistor de limitation 43 est connectée à la sortie 60 du circuit multiplicateur de tension 14. La grille de commande du deuxième transistor de limitation 18 est connectée à la sortie d'un inverseur 50 dont l'entrée est connectée à la sortie du comparateur 15. La grille de commande du transistor 18 reçoit donc le signal /CONTROL.

Les transistors 16 et 17 permettent de limiter le courant circulant dans les moyens de limitation. On évite ainsi une décharge trop rapide du condensateur équivalent 12 quand il est relié à la masse par le biais des transistors de limitation.

Le transistor de limitation 17 permet de ne limiter la tension interne VBS que dans la mesure où l'on dispose effectivement d'une tension de référence VREF égale à la tension inverse de la diode Zener. Ce n'est pas gênant dans la mesure où le signal d'horloge CK est commun aux deux circuits multiplicateurs de tension 6 et 14. Si ce transistor était absent, cela serait gênant puisque on limiterait la tension de sortie VBS à chaque fois que le signal d'horloge CK serait à l'état bas, les courants n'étant alors plus comparables dans les branches de l'étage différentiel 19. D'autre part, comme on s'intéresse à la limitation d'une tension obtenue à l'aide d'un circuit multiplicateur de tension, l'absence de limitation n'est pas dommageable dans la mesure où cette absence se produit alors que l'on ne transfère pas de charges en sortie de ce circuit. En effet, la tension présente aux bornes du condensateur équivalent 12 sera alors constante ou dégressive, mais ne pourra en aucun cas augmenter.

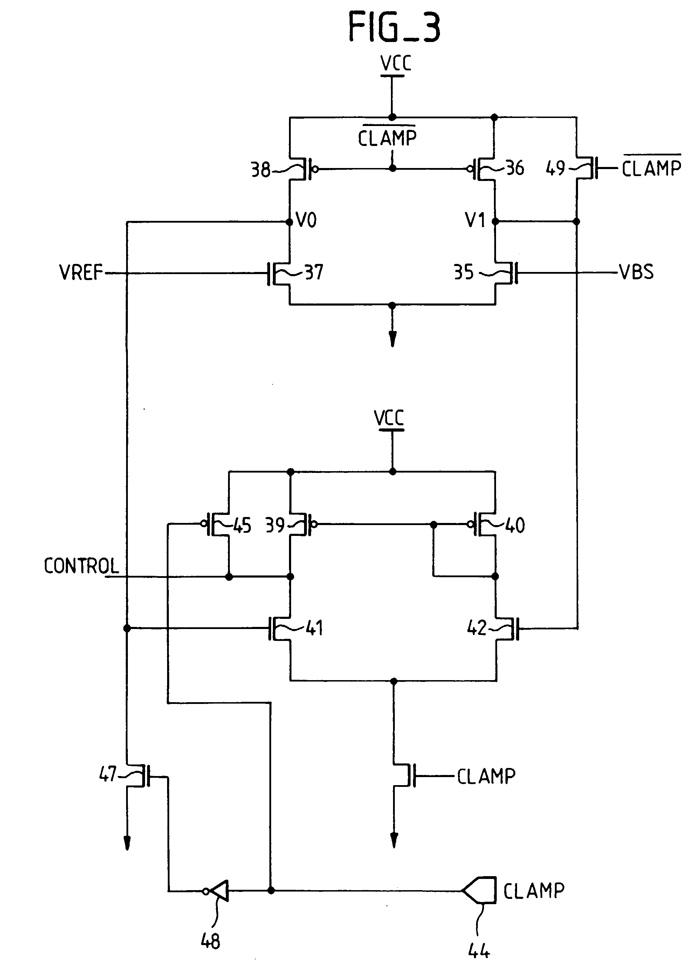

La figure 3 représente une partie du circuit régulateur 2 dans le cas où l'on souhaiterait inhiber la limitation de tension.

Le circuit régulateur 2 comportera une entrée 44 pour recevoir un signal de commande binaire CLAMP.

En ce qui concerne le comparateur 15, on ajoutera un transistor de type PMOS 45 un parallèle avec le transistor de type PMOS 39 de la première branche. D'autre part, on connectera la grille de commande du transistor de type NMOS 41 de cette même branche au drain d'un transistor de type NMOS 47 dont la source est connectée à la masse 4. La grille de commande de ce transistor 47 sera connectée à la sortie d'un inverseur 48 dont l'entrée sera connectée à l'entrée 44. Cette grille de commande recevra donc le signal /CLAMP. D'autre part, on pourra connecter en série un transistor de type NMOS 46 recevant le signal CLAMP sur sa grille de commande, entre les sources des transistors de type NMOS 41 et 42 du comparateur et la masse 4.

En ce qui concerne l'étage différentiel 19, les résistances 36 et 38 seront constituées de transistors de type PMOS recevant le signal /CLAMP sur leurs grilles de commande et on montera un transistor de type NMOS 49 en parallèle avec la résistance 38, la grille de commande de ce transistor 49 recevant le signal /CLAMP sur sa grille de commande.

Ainsi, quand on aura CLAMP = 0, on aura V1 = VCC, V0 = 0, CONTROL = 1 et /CONTROL = 0. Si CLAMP = 1, alors on aura CONTROL = 0 ou 1 suivant les valeurs respectives de V0 et V1.

## Revendications

1. Circuit régulateur de tension (2) pour limiter une tension d'alimentation interne (VBS) produite par un circuit d'alimentation (5) à partir d'une tension d'alimentation (VCC), ce circuit régulateur (2) comprenant une diode zener (13) pour produire une tension de référence (VREF), caractérisé en ce qu'il comprend en outre un étage différentiel dissymétrique (19) recevant en entrée les tensions interne (VBS) et de référence (VREF), cet étage (19) produisant à partir de la tension interne (VBS) et de la tension de référence (VREF) des tensions (V0, V1) de valeurs inférieures à la valeur de la tension d'alimentation (VCC), ces tensions (V0,V1) étant fournies à un comparateur (15) pour commander des moyens de limitation (18) afin de réguler la tension d'alimentation interne (VBS).

2. Circuit (2) selon la revendication 1, caractérisé en ce que l'étage différentiel dissymétrique (19) comprend deux entrées et deux sorties,
- la première entrée étant connectée à la grille de commande d'un premier transistor (35) monté en série avec une première résistance (36) entre une borne d'entrée d'alimentation (3) recevant la tension d'alimentation (VCC) et une borne de référence (4) recevant une deuxième tension de référence (GND),
- la deuxième entrée étant connectée à la grille de commande d'un deuxième transistor (37) monté en série avec une deuxième résistance (38) entre la borne d'entrée d'alimentation (3) et la borne de référence (4),
- la première sortie étant formée par le point milieu des premiers transistor (35) et résistance (36),
- la deuxième sortie étant formée par le point milieu des deuxièmes transistor (37) et résistance (38).

3. Circuit (2) selon l'une des revendications 1 à 2, caractérisé en ce qu'il comporte un deuxième circuit multiplicateur de tension (14) pour alimenter sur une sortie (60) la diode Zener (13).

4. Circuit (2) selon l'une des revendications 1 à 3, caractérisé en ce que les moyens de limitation (18) comprennent une résistance montée en série avec un transistor de limitation (18).

5. Circuit (2) selon la revendication 4, caractérisé en ce que le transistor de limitation (18) a sa grille de commande connectée à la sortie du comparateur (15).

6. Circuit (2) selon la revendication 3, caractérisé en ce que les moyens de limitation comprennent un deuxième transistor de limitation (43) dont la grille de commande est connectée à la sortie (60) du deuxième circuit multiplicateur de tension (14).

7. Circuit (2) selon l'une des revendications 1 à 6, caractérisé en ce qu'il comprend des moyens de commande pour inhiber le circuit régulateur de tension (2) quand un signal binaire de commande de limitation est dans un premier état.

8. Circuit intégré (1) caractérisé en ce qu'il comprend d'une part un circuit d'alimentation (5) pour produire une tension d'alimentation interne (VBS) à partir d'une tension d'alimentation (VCC), et d'autre part un circuit régulateur de tension (2) défini selon l'une des revendications 1 à 7.

9. Circuit intégré (1) selon la revendication 8, caractérisé en ce que le circuit d'alimentation (5) est un circuit multiplicateur de tension et en ce que la tension d'alimentation interne (VBS) est plus grande que la tension d'alimentation (Vcc).

10. Circuit intégré (1) selon l'une des revendications 8 ou 9, caractérisé en ce que ce circuit intégré (1) est une mémoire électriquement programmable.

## Patentansprüche

1. Spannungsregelschaltung (2) zum Begrenzen einer von einer Versorgungsschaltung (5) ausgehend von einer Versorgungsspannung (VCC) erzeugten internen Versorgungs spannung (VBS), wobei die Spannungs-Regelschaltung (2) eine Zenerdiode (13) zum Erzeugen einer Referenzspannung (VREF) umfaßt,
dadurch **gekennzeichnet**, daß
sie ferner eine asymmetrische differentielle Stufe (19) umfaßt, die eingangsseitig die interne Spannung (VBS) und die Referenzspannung (VREF) empfängt und ausgehend von der internen Spannung (VBS) und der Referenzspannung (VREF) Spannungen (V0, V1) mit Werten unterhalb des Werts der Versorgungsspannung (VCC) erzeugt, wobei diese Spannungen (V0, V1) einem Komparator (15) zugeführt werden, um Begrenzungsmittel (18) mit dem Zweck zu steuern, die interne Versorgungsspannung (VBS) zu regeln.

2. Schaltung (2) nach Anspruch 1,
dadurch gekennzeichnet, daß
die asymmetrische differentielle Stufe (19) zwei Eingänge und zwei Ausgänge umfaßt, wobei
- der erste Eingang an das Steuergate eines ersten Transistors (35) angeschlossen ist, der in Reihe mit einem ersten Widerstand (36) zwischen eine Versorgungs-Eingangsklemme (3), die die Versorgungsspannung (VCC) empfängt, und eine Referenzklemme (4) geschaltet ist, die eine zweite Referenzspannung (GND) empfängt,
- der zweite Eingang an das Steuergate eines zweiten Transistors (37) angeschlossen ist, der in Reihe mit einem zweiten Widerstand (38) zwischen die Versorgungs-Eingangsklemme (3) und die Referenzklemme (4) geschaltet ist,
- der erste Ausgang vom Mittelpunkt zwischen dem ersten Transistor (35) und dem Widerstand (36) gebildet ist,
- der zweite Ausgang vom Mittelpunkt zwischen dem zweiten Transistor (37) und dem Widerstand (38) gebildet ist.

3. Schaltung (2) nach einem der Ansprüche 1 bis 2,
dadurch gekennzeichnet, daß
sie eine zweite Spannungsmultiplikatorschaltung (14) zum Versorgen der Zenerdiode (13) an einem Ausgang (60) umfaßt.

4. Schaltung (2) nach einem der Ansprüche 1 bis 3,
dadurch gekennzeichnet, daß
die Begrenzungsmittel (18) einen in Reihe mit einem Begrenzungstransistor (18) geschalteten Widerstand umfassen.

5. Schaltung (2) nach Anspruch 4,
dadurch gekennzeichnet, daß
das Steuergate des Begrenzungstransistors (18) an den Ausgang des Komparators (15) angeschlossen ist.

6. Schaltung (2) nach Anspruch 3,
dadurch gekennzeichnet, daß
die Begrenzungsmittel einen zweiten Begrenzungstransistor (43) umfassen, dessen Steuergate an den Ausgang (60) der zweiten Spannungsmultiplikatorschaltung (14) angeschlossen ist.

7. Schaltung nach einem der Ansprüche 1 bis 6,
dadurch gekennzeichnet, daß
sie Steuermittel umfaßt, um die Spannungsregelschaltung (2) zu sperren, wenn ein binäres Begrenzungssteuersignal in einem ersten Zustand ist.

8. Integrierte Schaltung 1,
dadurch gekennzeichnet, daß
sie einerseits eine Versorgungsschaltung (5) zum Erzeugen einer internen Versorgungsspannung (VBS), ausgehend von einer Versorgungsspannung (VCC) und andererseits eine Spannungsregelschaltung (2) nach einem der Ansprüche 1 bis 7 umfaßt.

9. Integrierte Schaltung (1) nach Anspruch 8,
dadurch gekennzeichnet, daß
die Versorgungsschaltung (5) eine Spannungsmultiplikatorschaltung ist und daß die interne Versorgungsspannung (VBS) größer als die Versorgungsspannung (VCC) ist.

10. Integrierte Schaltung (1) nach einem der Ansprüche 8 oder 9,
dadurch gekennzeichnet, daß
die integrierte Schaltung (1) ein elektrisch programmierbarer Speicher ist.

## Claims

1. Voltage regulation circuit (2) for limiting an internal supply voltage (VBS) produced by a supply circuit (5) from a supply voltage (VCC), this regulation circuit (2) comprising a Zener diode (13) for producing a reference voltage (VREF), characterised in that it also comprises an asymmetrical differential stage (19) receiving at the input the internal (VBS) and reference (VREF) voltages, this stage (19) producing, from the internal voltage (VBS) and the reference voltage (VREF), voltages (V0, V1) with values lower than the value of the supply voltage (VCC), these voltages (V0, V1) being supplied to a comparator (15) to control limitation means (18) so as to regulate the internal supply voltage (VBS).

2. Circuit (2) according to Claim 1, characterised in that the asymmetrical differential stage (19) comprises two inputs and two outputs,
- the first input being connected to the control gate of a first transistor (35) mounted in series with a first resistance (36) between a supply input terminal (3) receiving the supply voltage (VCC) and a reference terminal (4) receiving a second reference voltage (GND),
- the second input being connected to the control gate of a second transistor 37' connected in series with a second resistance (38) between the supply input terminal (3) and the reference terminal (4),
- the first output being formed by the mid-point of the first transistor (35) and resistance (36),
- the second output being formed by the mid-point of the second transistor (37) and resistance (38).

3. Circuit (2) according to one of Claims 1 to 2, characterised in that it includes a second voltage multiplier circuit (14) for supplying the Zener diode (13) at an output (60).

4. Circuit (2) according to one of Claims 1 to 3, characterised in that the limitation means (18) comprise a resistance mounted in series with a limitation transistor (18).

5. Circuit (2) according to Claim 4, characterised in that the limitation transistor (18) has its control gate connected to the output of the comparator (15).

6. Circuit (2) according to Claim 3, characterised in that the limitation means comprise a second limitation transistor (43) whose control gate is connected to the output (60) of the second voltage multiplier circuit (14).

7. Circuit (2) according to one of Claims 1 to 6, characterised in that it comprises control means for inhibiting the voltage regulation circuit (2) when a binary limitation-control signal is in a first state.

8. Integrated circuit (1), characterised in that it comprises, firstly, a supply circuit (5) for producing an internal supply voltage (VBS) from a supply voltage (VCC), and secondly a voltage regulation circuit (2) defined according to one of Claims 1 to 7.

9. Integrated circuit according to Claim 8, characterised in that the supply circuit (5) is a voltage multiplier circuit and in that the internal supply voltage (VBS) is greater than the supply voltage (VCC).

10. Integrated circuit (1) according to one of Claims 8 or 9, characterised in that this integrated circuit (1) is an electronically programmable memory.
